# EUROPÄISCHE PATENTSCHRIFT

(11) **EP 0 672 310 B1**
(45) Veröffentlichungstag und Bekanntmachung des Hinweises auf die Patenterteilung: **31.07.1996**
(21) Anmeldenummer: 94900715.7
(22) Anmeldetag: 24.11.1993
(51) Int. Cl.: H01S 3/085, G02B 6/12

(54) **OBERFLÄCHENEMITTIERENDE LASERDIODE**
SURFACE-EMITTING LASER DIODE
DIODE LASER A EMISSION PAR LA SURFACE

(30) Priorität: 03.12.1992 DE 4240706
(43) Veröffentlichungstag der Anmeldung: 20.09.1995
(73) Patentinhaber: SIEMENS AKTIENGESELLSCHAFT, 80333 München (DE)
(72) Erfinder: KÖCK, Anton, Dr., D-81927 München (DE); GORNIK, Erich, Prof., D-80538 München (DE)
(86) Internationale Anmeldenummer: DE9301113
(87) Internationale Veröffentlichungsnummer: WO9413043

(56) Entgegenhaltungen:
- EP-A- 0 395 315
- EP-A- 0 442 002
- PATENT ABSTRACTS OF JAPAN vol. 9, no. 280 (E-356)(2003) 8. November 1985 & JP,A,60 123 084 (MATSUSHITA) 1. Juli 1985

## Beschreibung

Die vorliegende Erfindung betrifft eine oberflächenemittierende Laserdiode mit besonders guter Richtcharakteristik unter Ausnutzung der Anregung von Oberflächenplasmonpolaritonen.

In der EP-A-0 442 002 ist ein oberflächenemittierendes strahlungserzeugendes Halbleiterbauelement, das mittels Anregung von Oberflächenplasmonpolaritonen betrieben wird, beschrieben. Dieses Bauelement kann insbesondere als Laserdiode ausgestaltet sein. Die Struktur basiert auf einem Emissionsmechanismus über Anregung und Emission von Oberflächenplasmonpolaritonen, das sind transversal elektrische (TE) oder transversal magnetische (TM) Oberflächenmoden, die sich an der Grenzfläche zweier verschiedener Medien ausbreiten können. Bei geeigneter periodischer Strukturierung der Grenzfläche können diese Moden mit elektromagnetischen Wellen angeregt werden. Unter Anwendung dieses Emissionsmechanismus lassen sich die Eigenschaften von lichtemittierenden Dioden, insbesondere Laserdioden, verbessern. Bei herkömmlichen lichtemittierenden Bauelementen auftretende Verlustmechanismen, die den Wirkungsgrad begrenzen, können damit umgangen werden, wobei gleichzeitig die Linienbreite deutlich verringert und die externe Quantenausbeute drastisch erhöht wird. Eine gerichtete Abstrahlung mit definierter Polarisation mit einer Strahldivergenz von weniger als 6° ist erreichbar. Wesentlich für den Aufbau dieser Struktur sind dabei eine räumliche periodische Strukturierung der Oberfläche des Halbleitermateriales, d. h. die einem überwachsenen Substrat abgewandte Halbleiteroberfläche, und ein darauf aufgebrachter dünner Metallfilm. An der dem Halbleitermaterial abgewandten Oberfläche dieses Metallfilmes werden die Oberflächenmoden angeregt, so daß von der Oberfläche gerichtet Licht abgestrahlt wird. Die Polarisationsrichtung ergibt sich aus der Richtung der periodischen Anordnung der Oberflächenunebenheiten.

Aufgabe der vorliegenden Erfindung ist es, eine verbesserte oberflächenemittierende Laserdiode mit starker Strahlbündelung und vorgegebener Abstrahlrichtung anzugeben.

Diese Aufgabe wird mit der Laserdiode mit den Merkmalen des Anspruches 1 gelöst. Weitere Ausgestaltungen ergeben sich aus den abhängigen Ansprüchen.

Die erfindungsgemäße Laserdiode verwendet einen Schichtaufbau, wie er von herkömmlichen oberflächenemittierenden Laserdioden mit vertikalem Resonator grundsätzlich bekannt ist. Diese Struktur wird so modifiziert, daß die Abstrahlung des Lichtes über eine Anregung von Oberflächenmoden erfolgen kann.

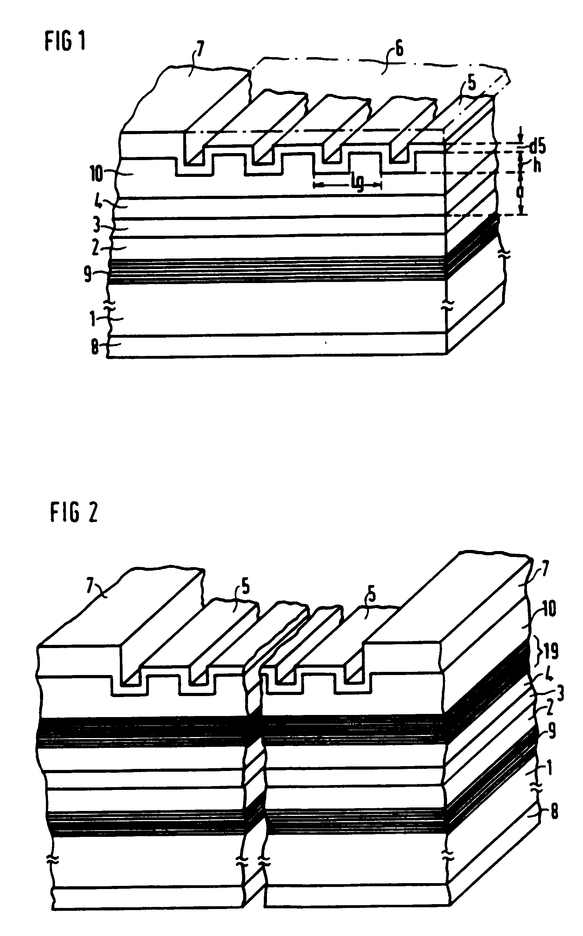

Es folgt eine Beschreibung der erfindungsgemäßen Laserdiode anhand der Figuren 1 und 2, die jeweils eine Ausführungsform in schräger Schnittaufsicht zeigen.

Die erfindungsgemäße Laserdiode besitzt eine Schichtstruktur mit einer aktiven Schicht 3 zwischen Kontaktschichten 2, 4, die für eine Stromzuführung in die aktive Schicht 3 vorgesehen sind. Zweckmäßig ist die gesamte Schichtanordnung auf ein Substrat 1 aufgewachsen. In der Oberfläche des Halbleitermateriales ist die räumliche periodische Strukturierung, die für die Anregung der Oberflächenmoden erforderlich ist, z. B. durch Ätzen, ausgebildet. In dem Ausführungsbeispiel der Figur 1 wird diese Oberfläche durch die Oberfläche einer Deckschicht 10, die auf die obere Kontaktschicht 4 aufgewachsen ist, gebildet. Auf diese strukturierte Oberfläche ist ein dünner Metallfilm 5, z. B. aus Aluminium, Gold oder Silber, aufgebracht. Die Dicke d5 dieses Metallfilmes 5 kann z. B. so gering sein, daß der Metallfilm 5 semitransparent ist. Typische Dicken d5 des Metallfilms 5 sind 0,01 µm bis 0,1 µm. In Fig. 1 sind weitere für die Anregung der Oberflächenmoden maßgebliche Bemessungen dieser Strukturierung der Oberfläche eingezeichnet. Wesentlich sind die Länge einer Periode Lg, der minimale Abstand a des Metallfilmes 5 von der aktiven Schicht 3 und die Höhe h, d. h. die Differenz des minimalen Abstandes und des maximalen Abstandes der mit dem Metallfilm 5 überzogenen Halbleiteroberfläche von der aktiven Schicht 3.

Ein Vertikalresonator ist in dieser Laserdiode ausgebildet, indem für die Erzeugung einer Resonanzbedingung in vertikal zu den Schichtebenen verlaufender Richtung Spiegel ober- und unterhalb der aktiven Schicht 3 angeordnet sind. In dem Ausführungsbeispiel der Figur 1 ist eine Spiegelanordnung 9 zwischen dem Substrat 1 und der unteren Kontaktschicht 2 vorgesehen. Den oberen Spiegel bildet der reflektierende Metallfilm 5. Die Spiegelanordnung 9 kann aus einer einzelnen Schicht oder aus einer Schichtfolge von aufeinanderfolgenden Halbleiterschichten mit unterschiedlichem Brechungsindex und vorteilhaft jeweils mit der Dicke einer viertel Wellenlänge bestehen. Besonders vorteilhaft bei der erfindungsgemäßen Laserdiode ist, daß eine gesonderte obere Spiegelanordnung entfallen kann, weil deren Funktion bereits durch den Metallfilm 5 übernommen werden kann. Die Deckschicht 10 kann dann auch entfallen und die Strukturierung in der Oberfläche der oberen Kontaktschicht 4 ausgebildet sein. Die für das Anlegen des Betriebsstromes erforderlichen Kontakte können bei leitfähigem Substrat 1 z. B. in der angegebenen Weise aufgebracht sein. Auf der Oberseite der Laserdiode ist dann ein Kontakt 7 vorhanden, der im Bereich der Strukturierung der Halbleiteroberfläche eine Aussparung aufweist, in der nur der dünne Metallfilm 5 aufgebracht ist. Es kann aber auch ganzflächig der Metallfilm 5 vorhanden sein, der dann als Kontakt für den elektrischen Anschluß ausreicht. Auf der Unterseite des leitfähigen Substrates 1 befindet sich der Gegenkontakt 8. Die untere Kontaktschicht 2 kann dann weggelassen sein und die Strominjektion in die aktive Schicht 3 durch die Spiegelanordnung 9 erfolgen. Wenn eine Kontaktschicht 2 vorhanden ist, kann der Gegenkontakt direkt auf einer nicht überwachsenen oder freigeätzten Oberfläche dieser Kontaktschicht 2 aufgebracht sein. Das Substrat 1 kann dann auch semiisolierend sein. Zusätzlich zu der gezeigten Struktur kann die Oberfläche des Metallfilmes 5 mit einem Dielektrikum 6, wie es in Fig. 1 durch die strichpunktierte Linie angedeutet ist, bedeckt sein. Wie in der EP-A-0 442 002 beschrieben ist, dient eine derartige Schicht aus Dielektrikum 6 zur Anregung von Oberflächenmoden höherer Ordnung. Dieses Dielektrikum 6 kann auch als Schichtfolge mehrerer verschiedener Dielektrika ausgebildet sein.

In Fig. 2 ist eine alternative Ausführungsform dargestellt, bei der auch oberhalb der aktiven Schicht eine eigene Spiegelanordnung 19 vorhanden ist. Diese Spiegelanordnung 19 befindet sich zwischen der oberen Kontaktschicht 4 und der Deckschicht 10. Bei einer Laserdiode, die im Materialsystem von GaAs aufgebaut ist, ist das Substrat z. B. GaAs. Die aktive Zone 3 ist ebenfalls GaAs. Die Kontaktschichten 2, 4 sind AlGaAs. Die Deckschicht 10 kann ebenfalls AlGaAs sein. Die Spiegelanordnungen 9, 19 sind vorteilhaft eine Folge von Schichten aus abwechselnd AlGaAs und AlAs. Die aktive Schicht 3 kann auch als Quantum-well-Struktur ausgebildet sein. Im Materialsystem von GaAs ist dann insbesondere eine aktive Schicht 3 aus einer Schichtfolge von Schichten aus abwechselnd GaAs und InGaAs vorteilhaft. InGaAs hat eine kleinere Energiebandlücke als GaAs, so daß dann die Spiegelanordnungen 9, 19 Schichtfolgen von Schichten aus abwechselnd AlAs und GaAs sein können, was das epitaktische Aufwachsen vereinfacht. Bei einem vereinfachten Aufbau dieser Laserdiode sind die obere Spiegelanordnung und die Deckschicht 10 weggelassen und die räumliche periodische Strukturierung der Oberfläche des Halbleitermateriales in der der aktiven Schicht 3 abgewandten Oberseite der oberen Kontaktschicht 4 ausgebildet. Die obere Spiegelanordnung 19 ist vorteilhaft eine Folge von Schichten unterschiedlichen Brechungsindexes mit jeweils der Dicke einer viertel Wellenlänge oder in der aktiven Schicht erzeugt.en Strahlung.

Eine herkömmliche oberflächenemittierende Laserdiode strahlt im wesentlichen senkrecht zur Oberfläche ab. Eine scharfe Richtungsbündelung der Lichtabstrahlung, wie sie bei der erfindungsgemäßen Laserdiode erfolgt, ist bei einer herkömmlichen Laserdiode nur durch zusätzliche optische Maßnahmen, wie z. B. eine Linse, erreichbar. Mit der erfindungsgemäßen Laserdiode ist über Oberflächenmodenemission zusätzlich eine Lichtemission in verschiedene vorgegebene Richtungen erreichbar. Durch die Anordnung der Oberflächenstrukturierung und die geeignete Wahl der oben angegebenen Bemessungen kann eine gerichtete Abstrahlung in bestimmte Winkel erfolgen. Außerdem kann die Polarisierungsebene des emittierten Lichtes eingestellt werden. Durch die Begrenzung der periodischen Strukturierung durch den dickeren oberen Kontakt 7 kann der Bereich der Strahlungsemission seitlich begrenzt sein. Der erfindungsgemäße Aufbau ist nicht auf das Materialsystem von GaAs beschränkt. Da die Dämpfung der Oberflächenmoden mit zunehmender Wellenlänge abnimmt, ist der Anregungs- und Emissionsmechanismus der Oberflächenmoden speziell im Infraroten besonders effektiv. Es muß lediglich die Gitterperiode der Wellenlänge angepaßt sein. Durch die Gitterperiode (Periodenlänge Lg) wird bei gegebener Wellenlänge der in der aktiven Schicht 3 erzeugten Strahlung die Abstrahlrichtung festgelegt. Durch die Bemessung der periodischen Strukturierung an der Oberfläche und die Wahl der Zusammensetzung des Halbleitermateriales der aktiven Schicht 3 kann daher die Abstrahlrichtung festgelegt werden. Die periodische Strukturierung kann wie in den Figuren gezeigt durch parallel zueinander ausgerichtete Gräben gebildet sein. In der Richtung dieser Gräben existiert keine Periodizität. Es kann statt dieser Ausführungsform jede in der EP-A-0 442 002 beschriebene Strukturierung vorgesehen sein. Insbesondere kann es sich um ein Kreuzgitter handeln, bei dem zwei senkrecht zueinander ausgerichtete Scharen von parallel zueinander angeordneten Gräben mit jeweils zu den nächstgelegenen Gräben gleichen Abständen vorhanden sind. Die Struktur ist dann in jeder Richtung in der Ebene des Schichtaufbaues periodisch. Die Gräben können durch kreuzweise ausgerichtete Scharen von parallel zueinander ausgerichteten Stegen mit jeweils zu den nächstgelegenen Stegen gleichen Abständen ersetzt sein oder dergleichen. Das Profil der Gräben oder Stege kann rechteckig sein oder gerundet, spitz, sinusförmig oder mehreckig.

Die erfindungsgemäße Laserdiode ermöglicht extrem gebündelte Oberflächenemission in eine vorgegebene Richtung bei einfach herstellbarem Aufbau des Bauelementes.

## Patentansprüche

1. Oberflächenemittierende Laserdiode aus Halbleitermaterial mit einer aktiven Schicht (3) und mit Kontakten (7, 8) zum Anlegen eines Betriebsstromes,
- bei der die von der aktiven Schicht (3) abgewandte emittierende Oberfläche des Halbleitermateriales mit einer räumlichen periodischen Struktur versehen ist,
- bei der zumindest auf einem mit dieser Strukturierung versehenen Bereich dieser Oberfläche ein Metallfilm (5) aufgebracht ist und
- bei der die Höhe (h) dieser Strukturierung, die Länge (Lg) jeweils einer Periode dieser Strukturierung, der minimale Abstand (a) des Metallfilmes (5) von der aktiven Schicht (3) und die Dicke (d5) des Metallfilmes (5) so bemessen sind, daß im Betrieb der Laserdiode an der der aktiven Schicht abgewandten Oberfläche des Metallfilmes (5) Oberflächenmoden durch in der aktiven Schicht (3) erzeugte Photonen angeregt werden,
**dadurch gekennzeichnet,**
daß auf der dieser Strukturierung abgewandten Seite der aktiven Schicht (3) eine Spiegelanordnung (9) zur Ausbildung eines Vernikalresonators als Schicht oder als Schichtfolge vorhanden ist.

2. Laserdiode nach Anspruch 1,
**dadurch gekennzeichnet**,
daß zwischen der aktiven Schicht (3) und dem Metallfilm (5) eine weitere Spiegelanordnung (19) vorhanden ist.

3. Laserdiode nach Anspruch 1,
dadurch gekennzeichnet,
daß der Vertikalresonator durch die Spiegelanordnung (9) und durch den Metallfilm (5) begrenzt ist.

4. Laserdiode nach Anspruch 3,
**dadurch gekennzeichnet**,
daß die aktive Schicht (3) zwischen vertikal zur Schichtebene daran angrenzenden Kontaktschichten (2, 4) angeordnet ist und daß die räumliche periodische Strukturierung in der Oberfläche einer twischen einer dieser Kontaktschichten (4) und dem Metallfilm (5) vorhandenen Deckschicht (10) ausgebildet ist.

5. Laserdiode nach einem der Ansprüche 1 bis 4,
**dadurch gekennzeichnet**,
daß der Metallfilm (5) in einer Aussparung eines Kontaktes (7) aufgebracht ist.

6. Laserdiode nach einem der Ansprüche 1 bis 4,
**dadurch gekennzeichnet**,
daß der Metallfilm (5) gleichzeitig einen Kontakt (7) bildet.

## Claims

1. Surface-emitting laser diode made of semiconductor material with an active layer (3) and with contacts (7, 8) for applying an operating current,
- in which the emitting surface, facing away from the active layer (3), of the semiconductor material is provided with a spatial periodic structure,
- in which a metal film (5) is applied at least to a region, provided with this structure, of this surface, and
- in which the height (h) of this structure, the length (Lg) of in each case one period of this structure, the minimum distance (a) of the metal film (5) from the active layer (3) and the thickness (d5) of the metal film (5) are dimensioned such that, during operation of the laser diode, surface modes are excited at the surface, facing away from the active layer (3), of the metal film (5) by photons produced in the active layer (3),
characterized
in that the reflector arrangement (9) for forming a vertical resonator is present as a layer or as a layer sequence on the side, facing away from this structure, of the active layer (3).

2. Laser diode according to Claim 1,
characterized
in that a further reflector arrangement (19) is present between the active layer (3) and the metal film (5).

3. Laser diode according to Claim 1,
characterized
in that the vertical resonator is bounded by the reflector arrangement (9) and by the metal film (5).

4. Laser diode according to Claim 3,
characterized
in that the active layer (3) is arranged between contact layers (2, 4) which adjoin said active layer vertically with respect to the layer plane, and
in that the spatial periodic structure is formed in the surface of a covering layer (10) which is present between one of said contact layers (4) and the metal film (5).

5. Laser diode according to one of Claims 1 to 4,
characterized
in that the metal film (5) is applied in a recess of a contact (7).

6. Laser diode according to one of Claims 1 to 4,
characterized
in that the metal film (5) at the same time forms a contact (7).

## Revendications

1. Diode laser à émission par la surface en matériau semi-conducteur, comportant une couche active (3) et des contacts (7, 8) pour appliquer un courant de service,
- dans laquelle la surface émettrice opposée à la couche active (3) du matériau semi-conducteur est pourvue d'une structure périodique spatiale,
- dans laquelle un film métallique (5) est appliqué sur au moins une zone de ladite surface pourvue de ladite structuration et
- dans laquelle la hauteur (h) de ladite structuration, la longueur (Lg) de respectivement une période de ladite structuration, la distance minimale (a) séparant le film métallique (5) de la couche active (3) et l'épaisseur (d5) du film métallique (5) sont calculées de sorte que lors du fonctionnement de la diode laser, des modes de surface sont excités à la surface du film métallique (5) opposée à la couche active (3) par des photons générés dans la couche active (3),
caractérisée en ce que pour constituer un résonateur vertical un dispositif de miroir (9) est prévu sous forme de couche ou de suite de couches sur la face opposée à ladite structuration de la couche active (3).

2. Diode laser selon la revendication 1, caractérisée en ce qu'un autre dispositif de miroir (19) est prévu entre la couche active (3) et le film métallique (5).

3. Diode laser selon la revendication 1, caractérisée en ce que le résonateur vertical est limité par le dispositif de miroir (9) et le film métallique (5).

4. Diode laser selon la revendication 3, caractérisée en ce que la couche active (3) est placée entre des couches de contact (2, 4) disposées verticalement par rapport au plan de couche et contiguës à celui-ci et en ce que la structuration périodique spatiale est réalisée dans une couche extérieure (10) prévue entre l'une desdites couches de contact (4) et le film métallique (5).

5. Diode laser selon l'une des revendications 1 à 4, caractérisée en ce que le film métallique (5) est placé dans un évidement d'un contact (7).

6. Diode laser selon l'une des revendications 1 à 4, caractérisée en ce que le film métallique (5) constitue en même temps un contact (7).
